# EUROPÄISCHE PATENTSCHRIFT

(11) **EP 0 430 861 B1**
(45) Veröffentlichungstag und Bekanntmachung des Hinweises auf die Patenterteilung: **15.02.1995**
(21) Anmeldenummer: 90710033.3
(22) Anmeldetag: 19.11.1990
(51) Int. Cl.: B23K 1/005, H05K 13/04

(54) **Laserlötsystem für SMD-Elemente**
Laser soldering system for SMD elements
Système de brasage au laser pour les éléments SMD

(30) Priorität: 01.12.1989 DE 3939812
(43) Veröffentlichungstag der Anmeldung: 05.06.1991
(73) Patentinhaber: TEMIC TELEFUNKEN microelectronic GmbH, 74072 Heilbronn (DE)
(72) Erfinder: Knödler, Dieter, W-7339 Eschenbach (DE); Möller, Werner, Dr., W-7900 Ulm (DE); Vayhinger, Kai-Uwe, W-7311 Hochdorf (DE)
(74) Vertreter: Maute, Hans-Jürgen, Dipl.-Ing.

(56) Entgegenhaltungen:
- EP-A- 0 241 154
- EP-A- 0 326 020
- PATENT ABSTRACTS OF JAPAN vol. 12, no. 164 (M-698)(3011) 18 Mai 1988,& JP-A-62 282773 (APOLLO SEIKO K.K.) 08 Dezember 1987,

## Beschreibung

Die Erfindung bezieht sich auf ein Laserlötsystem für SMD-Elemente gemäß dem Gattungsbegriff des Anspruchs 1.

Ein solches System, das mit einem CW-Nd:YAG-Laser im Einstrahlverfahren arbeitet, eine Steuerung über die Temperaturänderungsgeschwindigkeit aufweist, ist aus der DE-A1-37 01 013 und EP-A2-0 168 605 bekanntgeworden. Letzteres System arbeitet mit einem X-Y-Tisch und ist auch nur in diesen beiden Achsen bewegbar. Der Laserspot und die Bestrahlungsfläche sowie die Laserleistung pro Lötstelle sind konstant, lediglich die Laserleistungsdichte ist variabel. Beim Laserlöten müssen sehr enge Temperatur-Zeit-Toleranzen eingehalten werden, und zwar soll die Zeit minimal sein, die Temperatur nur knapp über dem Schmelzpunkt des Lotes, aber unter der Zersetzungstemperatur der Substrate und vor allem der thermischen Schädigung des Bauelementes, im vorliegenden Fall vorwiegend SMD's, liegen. Die Lötzeit des vorgenannten Systems beträgt über 0,1 sec pro Lötstelle und reicht bei Schaltungen mit hochpoligen Bauelementen bzw. zahlreichen Lötstellen an die Lötzeit der simultanen Stempel- und Reflowband-Lötverfahren heran. Ähnlich verhält es sich mit den Ausführungsformen gemäß US-PS 4 845 335 und den Anordnungen gemäß der Druckschrift JP-A-62-282 773, mit denen weder eine Prozessverkürzung noch eine Verbesserung der Reproduzierbarkeit erzielbar ist.

Der vorliegenden Erfindung liegt die Aufgabe zugrunde, ein System der eingangs genannten Art zu schaffen, bei dem die Lötzeiten so wesentlich verkürzt sind, daß auch hochpolige Bauelemente (SMD's) und Schaltungen mit vielen Bauelementen einer wirtschaftlichen Laserlötung unterzogen werden können, sehr kurze Lötzeiten mit entsprechend hohen Laserleistungen erfordern zur Vermeidung von Überhitzungen, Temperatursteuerungen sowie eine Optimierung der Z-Einstellung der Laseroptik bzw. der Bestrahlungsfläche, so daß die Laserleistung pro Lötstelle steuerbar ist.

Diese Aufgabe wird durch die im Anspruch 1 aufgezeigten Maßnahmen gelöst. In den Unteransprüchen sind Weiterbildungen und Ausgestaltungen angegeben und in der nachfolgenden Beschreibung sind Ausführungsbeispiele erläutert und in den Figuren der Zeichnung schematisch dargestellt. Es zeigen
- Fig. 1: eine Schemaskizze einer kompletten Laserlötanlage bestehend aus einem ersten und zweiten Roboter in einem Ausführungsbeispiel,
- Fig. 2: eine Ansicht des an einem Roboterflansch angeordneten Laserkopfes, der als schwenkbarer Modul-Laserkopf konzipiert ist,
- Fig. 3: eine Schemaskizze eines Ausführungsbeispiels für die Verlötung von gleichzeitig zwei Bauelementen mittels zweier Faseroptiken,
- Fig. 4: eine Schemaskizze der Laserstrahlführung zu dem Ausführungsbeispiel gem. Fig. 3 für einen Roboter mit Zweiachsensteuerung auf maximale Reflexion,
- Fig. 5: eine Schemaskizze des Bauelementen-Niederhalters in einem Ausführungsbeispiel mit einem Federstahlkreuz, einer Federstahlspinne oder einem Federstahlrahmen,
- Fig. 6: eine Schemaskizze der Laseroptik mit integrierter, koaxialer Gasdüse.

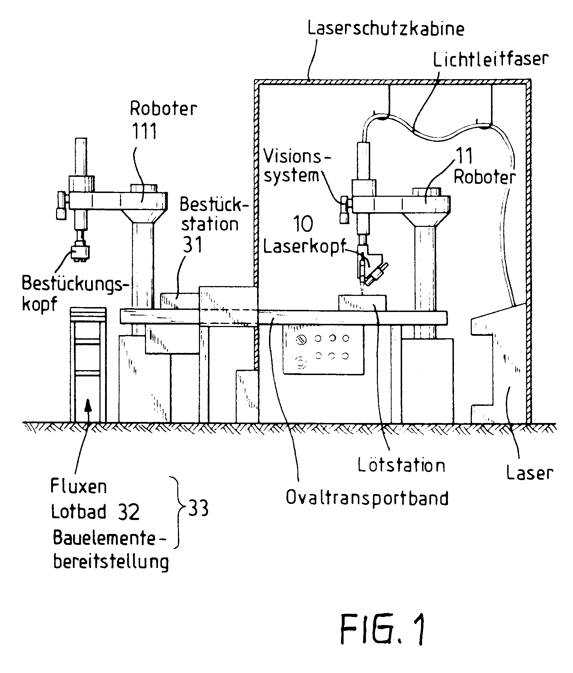

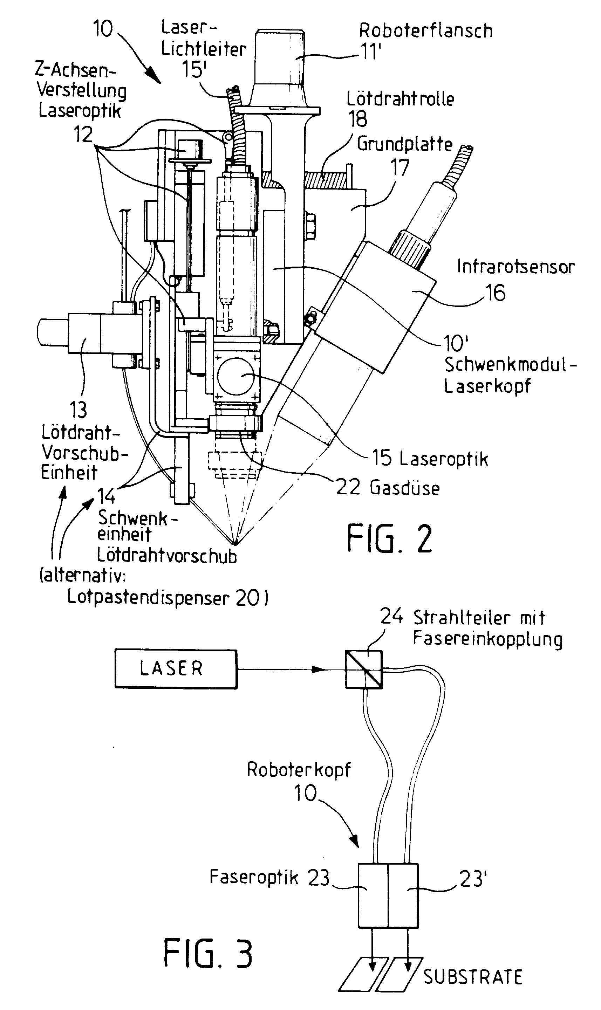

Die Fig. 1 zeigt in schematischer Darstellung das Ausführungsbeispiel einer Roboter-Laserlötanlage, die dem vorgeschlagenem Laserlötsystem entspricht. Diese Anlage setzt sich im wesentlichen aus einem ersten und einem zweiten Roboter 11, 111 zusammen. Der erste Roboter 11 ist über den Roboterflansch 11' mit einem sogenannten Laserkopf 10 versehen, der gemäß dem Ausführungsbeispiel nach Fig. 2 vorzugsweise als schwenkbarer Modul-Laserkopf 10' ausgebildet ist. Hierbei sind auf einer Grundplatte 17 die einzelnen nachstehend aufgeführten - Module befestigt, die untereinander in Wirkverbindung stehen. In erster Linie handelt es sich um eine als Modul ausgebildete rechnergesteuerte Lötdraht-Vorschubeinrichtung 13. Durch die Integration dieser Einrichtung 13 in den Lötvorgang mit der Verfahrenssteuerung der Roboter-Laserlötanlage wird nicht nur eine Prozeßverkürzung ermöglicht, sondern durch die Rechnersteuerung auch eine Verbesserung der Reproduzierbarkeit und Zuverlässigkeit erreicht.

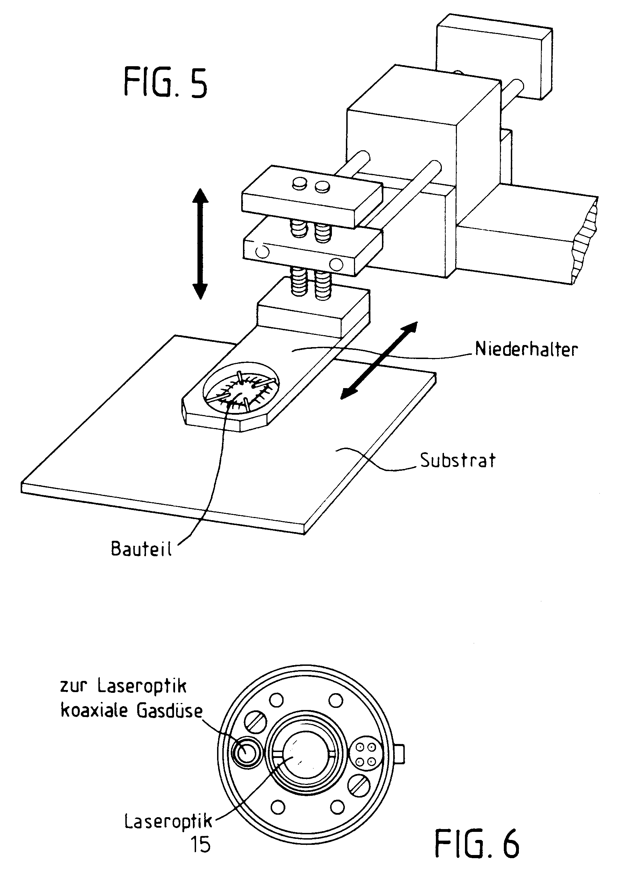

Die Vorbelotung erfolgt mit einem rechnergesteuerten Lötdraht- oder Lötpasten-Dispenser 20, der mit den gleichen, parallel versetzten Positionsdaten, Steuerungen und Einrichtungen - wie vorbeschrieben - gefahren wird. Der Dispenser 20 ist dadurch gekennzeichnet, daß er mit der gleichen Software, Rechnerformation und Positionierung wie der CW-Nd:YAG-Laser arbeitet. Dieser ist über Laserlichtleiter 15' mit dem Laserkopf 10 verbunden. Dieselbe Arbeitsweise - also Software, Rechnerformation und Positionierung wie der Laser - trifft auch für die voll integrierte Bauelemente-Bestückungseinrichtung 31 zu, die nach dem Durchlauf eines Oval-Transportbandes über einen Greiferwechsel erfolgt und mit dem Laserlötprozeß verbunden wird. Mit dem Begriff "Bauelemente" werden hier vorzugsweise die SMD-Elemente (Surface Mounted Device) K₁, K₂... bezeichnet. Die Bestückungseinrichtung 31 ist Bestandteil des zweiten Roboters 111. Die Plazierung der SMD's kann auch nach dem TAB-Verfahren (Tape Automated Bonding) erfolgen. Hiernach werden die Bauelemente auf einem 8, 16 oder 35 mm Rollfilm exakt positioniert, geprüft und erst vor dem Verlöten auf der Schaltung ausgestanzt. Die Bauelemente bzw. SMD's werden vorzugsweise vor dem Verlöten in einem Zwischenschritt in eine spezielle Flußmittelpaste oder -lösung mit den Anschlüssen eingetaucht. Diese Flußmittellösung absorbiert das Laserlicht, trocknet schnell oder enthält ein nur wenig verdampfendes Lösungsmittel. Vorgeschlagene Flußmittel sind beispielsweise 5 bis 30%ige Nigrosin- oder Colophonium-Lösungen. Unmittelbar nach dem Tauchen werden die SMD's auf der Schaltung abgesetzt (Fig. 5) während des Lötprozesses angedrückt. Hierdurch wird vermieden, daß das SMD auf dem Lot "schwimmt", was bei kalten Leiterplatten häufig vorkommt.

Bei dünnen Drahtanschlüssen, wie sie bei TAB-SMD's üblich sind, können die Bauelement-Anschlüsse mittels eines matrizzenartigen Quarzglasstempels angedrückt und lasergelötet weden, denn das Quarzglas ist für den Laserstrahl durchlässig. Besonders haben sich ringförmige Halterungen aus hochschmelzenden Metallen zum Andrücken der Anschlüsse als geeignet erwiesen.

Auf Flußmittel und damit auf die nachfolgende zeitraubende Reinigung kann verzichtet werden, wenn mit einem aus 10%H₂ und 90% N₂ bestehenden Formiergas die Lötstelle angeblasen und für eine in der Laserfackel reduzierende Atmosphäre gesorgt wird. Die Formiergas-Anblasung erfolgt pneumatisch nur während des kurzen Laserpulses, so daß bei sensorisch gesteuerter Umluft oder Absaugung nicht mit einer Explosionsgefahr gerechnet werden muß. Außerdem werden hierdurch Feuchte, Flußmittel und Löt-Dämpfe abgetrieben und auch das Beschlagen der IR- und Laseroptiken vermieden. Anstelle von Formiergas eignet sich auch Stickstoffgas, das in einer sogenannten "Waschflasche" mit einer Methanol/Ameisensäure-Lösung vorher gespült wurde.

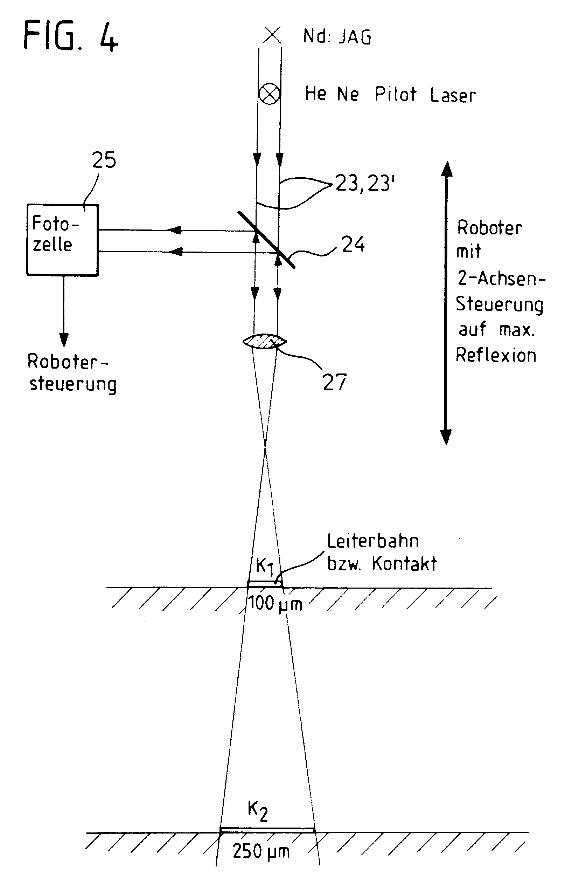

In einem speziellen Ausführungsbeispiel (Fig. 3, Fig. 4) läßt sich der Lötvorgang fertigungstechnisch dadurch verdoppeln und somit die Fertigungszeit reduzieren, wenn über einen Strahlteiler 24 zwei Faseroptiken 23, 23' an den Laser angeschlossen und simultan - z.B. bei Nutzensubstraten - zwei Schaltungen (Leiterbahn und Kontakt) K₁, K₂ in gleicher Weise gelötet werden. Die einzelnen Verfahrensschritte lassen sich über einen einzigen Roboterarm durchführen und über ein angekoppeltes Visionssystem bzw. Bildauswerteverfahren die Positionierungszuordnung erleichtern. Hierdurch wird das Robotersystem besser ausgenutzt und die Vorrichtungen einfacher.

Das Bildauswerteverfahren arbeitet in bekannter Weise gemäß dem bekannten Stand der Technik, so daß hierzu weitere Erläuterungen nicht gebracht werden müssen.

Eine weitere Verkürzung und Optimierung des Temperatur-Zeit-Verlaufes erreicht man durch eine Anpassung des Laserspots an die Lötstellengeometrie, indem die Z-Lage der Laserlinse 27 oder des Laserkopfes 10 durch eine Z-Achsen-Verstelleinrichtung 12 mittels der Robotersteuerung geändert wird (Fig. 4). Bekanntlich sind die Geometrien der SMD-Bauelemente sehr unterschiedlich und erfordern eine entsprechende Anpassung. Der fokussierende Laserstrahl 23 bzw. 23' ändert in Z-Richtung deutlich seine Fläche. Durch eine kontrollierte Laserleistungsänderung wird die Strahldichte angepaßt oder die Lötzeit damit zusätzlich noch geändert. Diese Laserleistungsänderung wird ebenfalls mittels PC programmiert.

Die Optimierung der Z-Einstellung kann nach dem sogenannten "Double-Beam-Prinzip" über eine Beleuchtungsstärkemessung erfolgen. Bei allen mit einem Spiegelsystem arbeitenden Lötlasern ist diese geometrische Anpassung bisher nicht möglich, ebenso nicht eine automatische Lötdrahtzuführung.

Das in Fig. 2 der Zeichnung dargestellte Ausführungsbeispiel eines Schwenk-Modul-Laserkopfes 10' setzt sich aus mehreren auf einer Grundplatte angeordneten Modulen zusammen. In erster Linie aus dem Modul der Laseroptik 15 mit dem Laser-Lichtleiter 15', weiterhin des ansetzbaren und einstellbaren Infrarot-Sensors 16 sowie dem Modul der Lötdraht-Vorschubeinrichtung 13, der eine Schwenkeinheit 14 zugeordnet ist sowie eine abspulbare Lötdrahtrolle 18. Ein weiterer Modul bildet die Z-Achsenverstelleinrichtung 12 für die Laseroptik 15. Die Grund- oder Modulträgerplatte 17 ist am Roboterflansch 11' befestigt. Ebenfalls mit dem bzw. den Roboter(n) 11, 111 bzw. deren Rechner- und Steuereinheiten verbunden sind die einzelnen genannten Elektroniken der genannten Module.

In Fig. 2 ist schematisch der Laserkopf 10 mit dem rechnergesteuerten Lötdraht- oder Lötpasten-Dispenser 20 dargestellt. Weiterhin ist die Anordnung des IR-Sensors (16) zur Laser-Temperatur/Zeit-Steuerung sowie des rechnergesteuerten Motors zur Lötdrahtzuführung 13 mit dem Laseroptik 15, der oder den Gasdüsen 22 für das Formiergas und die Lötdrahtreserve gezeigt.

Abschließend sei noch auf die Vorbelotung eingegangen, die ebenfalls mit dem vorbeschriebenen Laserlötsystem vorgenommen werden kann. Eine Vorbelotung der Leiterbahnen und der SMD's durch die Einrichtung 32 des zweiten Roboters 111 in hinreichender Schichtstärke erbringt bereits die erste Zeitverkürzung. Eine Vorbelotung des Substrates oder der Bauelementenanschlüsse galvanisch, im Lötbad oder mittels Lotdraht erbringt eine direkte Schnellverlötung, ohne daß eine zusätzliche Lotzuführung als Stanzteil, Paste oder Draht notwendig ist.

Ein weitere Art der Vorbelotung ist durch eine Feindrahtvorbelotung gegeben, die z.B. auf IC's sogenannte Löthöcker für das TAB-Verfahren aufbringt, die sich mit einem temperaturdefinierten Stempel kalibrieren oder egalisieren lassen. Beim TAB-Verfahren kann die hier übliche Thermomode verwendet werden.

Die Einrichtung 33 für das Fluxen entspricht der bei Lötanlagen üblichen Vorrichtung (Walze, Bürste, Schwammrolle).

## Patentansprüche

1. Laserlötsystem zur automatischen, positions- und temperaturgesteuerten Laser-Mikrolötung von SMD-Elementen (K₁, K₂...) unter Verwendung eines CW-Nd:YAG-Lasers, das eine Temperatur- und Zeitsteuerung und deren Kontrolle sowie eine Temperatur-Gradienten-Steuerung und einen ersten Mehrachsenroboter (11) mit einem Laserkopf (10) aufweist, der mit Steuereinrichtungen (12, 14, 16) für den Laserspot, die Bestrahlungsfläche und die Laserleistung pro Lötstelle versehen ist und in dem eine rechnergesteuerte Lötdraht-Vorschubeinrichtung (13) mit einem rechnergesteuerten Lötdraht- oder Lötpasten-Dispenser (20) integriert ist, die an seine Verfahrenssteuereinrichtungen angeschlossen ist und dem ein zweiter Mehrachsenroboter zugeordnet ist, **dadurch gekennzeichnet,**
a) daß der Laserkopf (10) eine oder mehrere Gasdüsen (22) für ein Schutz- und Formiergas und mehrere Laseroptiken (15) aufweist,
b) daß zur Anpassung des Laserspots an die Lötstellengeometrie die Laser-Fokussierlinse (27) oder der Laserkopf (10) In die Z-Richtung mittels einer Verstelleinrichtung (12) über die Robotersteuerung verschieb- und verschwenkbar ausgebildet ist,
c) daß der zweite Mehrachsenroboter (111) mit Einrichtungen für die Bestückung (31), für die Vorbelotung (32), für das Fluxen (33) und einem Niederhalter für das zu verlötende SMD-Element (K1, K2..) versehen ist,
d) daß die Einrichtung für das Fluxen (33) der Anschlüsse der SMD-Elemente (K1, K2) vor dem Bestücken und Verlöten eine laserlichtabsorbierende, schnell trocknende Flußmittellösung aufweist,
e) daß das Formiergas aus 10 % H₂ und 90 % N₂ besteht,
f) daß der einen oder den mehreren Gasdüsen (22) ein H₂-Sensor zugeordnet ist, mit dessen Hilfe beim Verlötvorgang die Schutz- oder Formiergas-Anblasung kontrolliert wird,
g) und daß dem Schutz- oder Formiergas für die Anfeuchtung und Spülung eine "Waschflasche" mit Methanol/Ameisensäure vorgeschaltet ist.

2. Laserlötsystem nach Anspruch 1, **dadurch gekennzeichnet,** daß der Lötdraht- oder Lötpasten-Dispenser (20) mit der gleichen Rechnerformation und Positionierung wie der CW-Nd:YAG-Laser arbeitet.

3. Laserlötsystem nach den Ansprüchen 1 oder 2, **dadurch gekennzeichnet,** daß der Lötdraht-Vorschub-Einrichtung (13) eine Schwenkeinheit (14) zugeordnet ist.

4. Laserlötsystem nach den Ansprüchen 1 bis 3, **dadurch gekennzeichnet,** daß die Bauelemente-Bestückungseinrichtung (31) über einen Greiferwechsel angekoppelt ist.

5. Laserlötsystem nach einem der Ansprüche 1 bis 4, **dadurch gekennzeichnet,** daß die SMD-Elementanschlüsse (K1, K2) eine Laserlicht absorbierende Schicht oder Oberflächen aufweisen.

6. Laserlötsystem nach Anspruch 5, **dadurch gekennzeichnet,** daß als lichtabsorbierende Lösung 5 bis 30%ige Nigrosin- oder Colophonium-Lösungen verwendet werden.

7. Laserlötsystem nach einem der Ansprüche 1 bis 6, **dadurch gekennzeichnet,** daß zum Niederhalten der SMD-Elementanschlüsse (K1, K2..) während des Verlötens ein Quarzglasstempel vorgesehen ist.

8. Laserlötsystem nach einem der Ansprüche 1 bis 6, **dadurch gekennzeichnet,** daß zum Niederhalten der SMD-Elemente (K1, K2..) während des Verlötens eine Federstahlspinne, die die Abschlüsse diagonal ausspart, vorgesehen ist.

9. Laserlötsystem nach einem der Ansprüche 1 bis 8, **dadurch gekennzeichnet,** daß zur simultanen Verlötung von gleichzeitig zwei Bauelementen (SMD) (K1, K2) zwei Faseroptiken (23, 23') über einen Strahlteiler (24) mit dem CW-Nd:YAG-Laser und gegebenenfalls einer Fotozelle (25) mit der Robotersteuerung gekoppelt sind, wobei der Roboter (11) eine Zweiachsensteuerung auf maximale Reflexion aufweist.

10. Laserlötsystem nach einem der Ansprüche 1 bis 9, **dadurch gekennzeichnet,** daß zum Variieren der Laserstrahldichte und damit der Lötzeit eine Laserleistungs-Meß- und Einstelleinrichtung und eine PC-Programmiereinrichtung vorgesehen ist.

## Claims

1. Laser soldering system for automatic position- and temperature-controlled laser microsoldering of SMD elements (K₁, K₂...) using a CW-Nd:YAG laser which has a temperature and time control and monitoring thereof as well as a temperature gradient control and a first multiple-axis robot (11) with a laser head (10) which is provided with control devices (12, 14, 16) for the laser spot, the irradiation surface and the laser power per soldering point and in which is integrated a computer-controlled soldering wire feeding device (13) with a computer-controlled dispenser (20) for soldering wire or soldering paste which device is connected to the process control devices of the said robot, a second multiple-axis robot being co-ordinated with the first, characterised in that
a) the laser head has one or more gas jets (22) for a buffer and forming gas and a plurality of laser optical systems (15),
b) for adaptation of the laser spot to the geometry of the soldering points the laser focussing lens (27) or the laser head (10) is constructed so that it can be moved or swivelled in the Z direction by means of an adjusting device (12) by way of the robot control,
c) the second multiple-axis robot (111) is provided with devices for fitting (31), for preliminary soldering (32), for fluxing (33) and with a device for holding the SMD element (K₁, K₂...) to be soldered,
d) the device for fluxing (33) the contacts of the SMD elements (K₁, K₂...) before the fitting and soldering has a quick-drying fluxing agent solution which absorbs laser light,
e) the forming gas consists of 10% H₂ and 90% N₂,
f) an H₂ sensor, with the aid of which the blowing on of the buffer or forming gas is monitored, is coordinated with the one or more gas jets (22),
g) and for the dampening and rinsing a "washing flask" with methanol/formic acid precedes the buffer or forming gas.

2. Laser soldering system according to Claim 1, characterised in that the dispenser (20) for soldering wire or soldering paste operates with the same computer formation and positioning as the CW-Nd:YAG laser.

3. Laser soldering system according to Claims 1 or 2, characterised in that a swivel unit (14) is co-ordinated with the soldering wire feeding device (13).

4. Laser soldering system according to Claims 1 to 3, characterised in that the component fitting device (31) is linked in by way of a gripper alternator.

5. Laser soldering system according to one of Claims 1 to 4, characterised in that the SMD element contacts (K₁, K₂) have a laser light absorbing layer or surfaces.

6. Laser soldering system according to Claim 5, characterised in that 5 to 30% nigrosine or colophony solutions are used as the light-absorbing solution.

7. Laser soldering system according to one of Claims 1 to 6, characterised in that a quartz glass die is provided to hold down the SMD element contacts (K₁, K₂...) during the soldering.

8. Laser soldering system according to one of Claims 1 to 6, characterised in that a spring steel spider which diagonally clears the terminations is provided to hold down the SMD elements (K₁, K₂...).

9. Laser soldering system according to one of Claims 1 to 8, characterised in that for simultaneous soldering of two (SMD) components (K₁, K₂) two fibre optic systems (23, 23') are connected by way of a beam divider (24) to the CW-Nd:YAG laser and optionally by way of a photoelectric cell (25) to the robot control, the robot (11) having a twin-axis control for maximum reflection.

10. Laser soldering system according to one of Claims 1 to 9, characterised in that a device for measuring and adjusting the laser power and a PC programming device are provided in order to vary the laser beam density and thus the soldering time.

## Revendications

1. Système de brasage par laser pour le microbrasage par laser automatique, commandé en position et température, d'éléments de SMD (dispositif monté en surface) (K₁, K₂ ...), avec emploi d'un laser CW-Nd : YAG, qui présente une commande de température et de temps et des contrôles de celle-ci, ainsi qu'une commande de gradient de température, et un premier robot (11) à plusieurs axes avec une tête de laser (10), qui est pourvue d'agencements de commande (12, 14, 16) pour le spot de laser, la surface d'irradiation et la puissance de laser par emplacement de brasage, et dans laquelle, un agencement d'avance de fil de brasage (13) commandé par calculateur, avec un distributeur (20) de fil de brasage ou de pâte de brasage commandé par calculateur, est intégré, qui est raccordé à ses agencements de commande de procédé, et auquel est associé un deuxième robot à plusieurs axes, caractérisé en ce que :
a) la tête de laser (10) présente une ou plusieurs buses de gaz (22), pour un gaz de protection et de formation, et plusieurs optiques de laser (15)
b) pour l'adaptation du spot de laser à la géométrie d'emplacement de brasage, la lentille de focalisation de laser (27), ou la tête de laser (10), est constituée susceptible d'être translatée et pivotée dans la direction Z, au moyen d'un agencement de déplacement (12), par l'intermédiaire de la commande de robot,
c) le deuxième robot (111) à plusieurs axes est pourvu d'agencements pour le garnissage (31), pour le prébrasage (32), pour l'amenée de décapant de brasage (33) et d'un dispositif de maintien en position basse pour l'élément de SMD (K1, K2 ...) à braser,
d) l'agencement pour l'amené de décapant de brasage (33) aux raccordements des éléments de SMD (K1, K2), avant le garnissage et le brasage, présente une solution d'agent de décapage et de brasage absorbant de la lumière de laser, séchant rapidement,
e) le gaz de formation consiste en 10 % de H₂ et 90 % de N₂,
f) à une ou aux plusieurs buses de gaz (22), est associé un capteur de H₂, à l'aide duquel, lors de l'opération de brasage, le soufflage de gaz de protection ou de formation est contrôlé,
g) et en ce qu'au gaz de protection ou de formation, pour l'humidification et le rinçage, une "bouteille de lavage" avec du méthanol/de l'acide formique est mise en circuit en amont.

2. Système de brasage par laser selon la revendication 1, caractérisé en ce que le distributeur (20) de fil de brasage ou de pâte de brasage travaille avec les mêmes formation de calculateur et positionnement que le laser CW-Nd : YAG.

3. Système de brasage par laser selon la revendication 1 ou la revendication 2, caractérisé en ce qu'à l' agencement (13) d'avance de fil de brasage, est associée une unité de pivotement (14);

4. Système de brasage par laser selon les revendications 1 à 3, caractérisé en ce que l'agencement (31) de garnissage de composants est accouplé par l'intermédiaire d'un dispositif de changement de saisie.

5. Système de brasage par laser selon une des revendications 1 à 4, caractérisé en ce que les raccordements d'élément de SMD (K1, K2) présentent une couche ou des surfaces absorbant de la lumière de laser.

6. Système de brasage par laser selon la revendication 5, caractérisé en ce que, comme solution absorbant de la lumière, 5 à 30 % de solutions de nigrosine ou de colophane sont employés.

7. Système de brasage par laser selon une des revendications 1 à 6, caractérisé en ce qu'au dispositif de maintien en position basse des raccordements d'élément de SMD (K1, K2...), durant le brasage, est prévu un piston de verre quartzeux.

8. Système de brasage par laser selon une des revendications 1 à 6, caractérisé en ce qu'au dispositif de maintien en position basse des éléments de SMD (K1, K2...), durant le brasage, un croisillon d'acier à ressort, qui épargne les fermetures en diagonale, est prévu.

9. Système de brasage par laser selon une des revendications 1 à 8, caractérisé en ce que, pour le brasage simultané en même temps de deux composants (SMD) (K1, K2), sont couplées deux optiques à fibre (23, 23'), par l'intermédiaire d'un diviseur de rayon (24), avec le laser CW-Nd : YAG, et, le cas échéant d'une photocellule (25), avec la commande de robot, le robot (11) présentant une commande à deux axes sur réflexion maximale.

10. Système de brasage par laser selon une des revendications 1 à 9, caractérisé en ce que pour la variation de la densité de rayon de laser et, par suite, du temps de brasage, un agencement de contrôle de programme PC est prévu.
